(19) **Europäisches Patentamt / European Patent Office / Office européen des brevets**

(11) **EP 2 915 184 B1**

(12) **FASCICULE DE BREVET EUROPEEN**

(45) Date de publication et mention de la délivrance du brevet:
**14.09.2016   Bulletin 2016/37**

(51) Int Cl.:
*H01L 21/762* (2006.01)      *H01L 29/06* (2006.01)
*H01L 41/09* (2006.01)      *H01L 21/20* (2006.01)
*H01L 23/538* (2006.01)

(21) Numéro de dépôt: **13812060.5**

(22) Date de dépôt: **11.10.2013**

(86) Numéro de dépôt international:
**PCT/IB2013/002292**

(87) Numéro de publication internationale:
**WO 2014/068377 (08.05.2014 Gazette 2014/19)**

(54) **PROCEDE DE MODIFICATION D'UN ETAT DE CONTRAINTE INITIAL D'UNE COUCHE ACTIVE VERS UN ETAT DE CONTRAINTE FINAL**

VERFAHREN ZUR MODIFIZIERUNG EINES ANFÄNGLICHEN SPANNUNGSZUSTANDS EINER AKTIVEN SCHICHT IN EINEN ENDGÜLTIGEN SPANNUNGSZUSTAND

METHOD FOR MODIFYING AN INITIAL STRESS STATE OF AN ACTIVE LAYER TO A FINAL STRESS STATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **31.10.2012   FR 1202939**

(43) Date de publication de la demande:
**09.09.2015   Bulletin 2015/37**

(73) Titulaire: **Soitec**
**38926 Crolles Cedex (FR)**

(72) Inventeurs:
• **LE VAILLANT, Yves-Matthieu**
  **F-38920 Crolles (FR)**
• **NAVARRO, Etienne**
  **F-38000 Grenoble (FR)**

(74) Mandataire: **Grünecker Patent- und Rechtsanwälte PartG mbB Leopoldstraße 4 80802 München (DE)**

(56) Documents cités:
**US-A1- 2006 141 742      US-A1- 2007 037 323**

## Description

La présente invention se rapporte à un procédé de modification d'un état de contrainte initial d'une couche dite active vers un état de contrainte final, ainsi qu'à une structure pour la modification d'un état de contrainte initial d'une couche active vers un état de contrainte final.

Par « couche active », on entend une couche (ou une pluralité de sous-couches) sur laquelle ou dans laquelle seront fabriqués des composants destinés à des applications notamment dans les domaines de la microélectronique, l'optique, l'optoélectronique, la piézoélectricité ou encore la spintronique.

Par « état de contrainte », on entend les contraintes résultant des efforts internes mis en jeu entre des portions déformées de la couche utile, les efforts internes pouvant être en tension ou en compression. Lorsque les efforts internes sont nuls ou quasi nuls, on parlera d' « état relaxé » pour désigner l'état de contrainte correspondant.

La mise en contrainte (en tension ou en compression) d'une couche active réalisée dans un matériau semi-conducteur est notamment utilisée pour modifier les structures de bandes électroniques. Ceci a pour conséquence de modifier les propriétés de transport électronique ou les propriétés électromagnétiques. Du point de vue électronique, la mobilité des porteurs peut être améliorée. Du point de vue électromagnétique, la modification de l'état de contrainte entraîne une modification des bandes de valence et de conduction, éventuellement du type de bande interdite (directe ou indirecte) des semi-conducteurs et des isolants.

L'amélioration des performances des composants nécessite une couche active avec un niveau de contrainte élevé, ce qui implique une couche active pouvant subir une déformation (ou autrement dit un allongement relatif) important. Ainsi, plus précisément on cherche à obtenir une couche active pouvant subir une déformation supérieure à 0,75 %, voire supérieure à 1%, sans création de défauts.

Le document US 2007/0037323 publié le 15 Fev 2007 décrit une méthode de fabrication d'une couche en silicium contraint. Le procédé est adapté pour le collage de substrats ayant des épaisseurs du même ordre de grandeur.

Le document intitulé « Fabricating Strained Silicon Substrates Using Mechanical Deformation during Wafer Bonding » de K.T. Turner, ECS Transactions, 16(8) 321-328 (2008), dénommé ci-après D1, divulgue (voir notamment figure 2) un procédé de modification d'un état de contrainte initial d'une couche active vers un état de contrainte final, le procédé comportant les étapes a) fournir un premier substrat comprenant la couche active dans l'état de contrainte initial, la couche active étant réalisée dans un premier matériau présentant un module d'Young noté $E_1$, la couche active présentant une épaisseur notée $h_1$ ; b) fournir un deuxième substrat réalisé dans un deuxième matériau présentant un module

d'Young noté $E_2$, le deuxième substrat présentant une épaisseur notée $h_2$, le deuxième substrat présentant une forme initiale au repos ; c) incurver le premier substrat et le deuxième substrat de sorte qu'ils présentent chacun une forme arquée d'un rayon de courbure noté R sensiblement identique ; d) assembler le deuxième substrat à la couche active de sorte que le deuxième substrat épouse la forme du premier substrat ; e) rétablir la forme initiale au repos du deuxième substrat de sorte que la couche active présente l'état de contrainte final.

D1 divulgue à travers la comparaison des figures 4(a) et 4(b) et du premier paragraphe page 327 qu'il est préférable d'utiliser un deuxième substrat avec un deuxième matériau vérifiant la relation $E_2=E_1$ (c'est-à-dire $E_2/E_1=1/\Sigma=1$ en suivant les notations de D1) pour un rapport d'épaisseurs $h_2/h_1$ donné ($h_2/h_1=1/\xi=10^3$). D1 enseigne qu'un tel deuxième substrat en conjugaison avec la réduction de l'épaisseur du premier substrat après l'étape d) d'assemblage permet d'obtenir des déformations élevées et donc des contraintes élevées dans la couche active. A contrario, D1 enseigne que la souplesse du deuxième substrat ($\Sigma=100$) relativement au premier substrat, en conjugaison avec la réduction de l'épaisseur du premier substrat après l'étape d) d'assemblage, conduit uniquement à 70% de la valeur des contraintes obtenues pour $\Sigma=1$, pour le même rapport d'épaisseurs $h_2/h_1$ donné ($h_2/h_1=1/\xi=10^3$).

Le procédé décrit dans D1 n'est pas entièrement satisfaisant dans la mesure où, lorsque le premier substrat présente une raideur importante, par exemple si le premier substrat est réalisé dans un premier matériau semi-conducteur, tel que le silicium, alors le deuxième substrat présente également une raideur importante de manière à vérifier $\Sigma=1$. Un tel deuxième substrat peut alors difficilement être incurvé lors de l'étape c) sans occasionner des défauts lorsque l'on souhaite obtenir une couche active avec une déformation supérieure à 0,75 %, et ce d'autant plus que les dimensions du deuxième substrat sont importantes (par exemple $h_2/h_1=1/\xi=10^3$).

La présente invention vise à remédier à l'inconvénient précité, et concerne un procédé de modification d'un état de contrainte initial d'une couche dite active vers un état de contrainte final noté $\varepsilon$, le procédé comportant les étapes a) fournir un premier substrat comprenant la couche active dans l'état de contrainte initial, la couche active étant réalisée dans un premier matériau présentant un module d'Young noté $E_1$, la couche active présentant une épaisseur notée $h_1$ ; b) fournir un deuxième substrat réalisé dans un deuxième matériau présentant un module d'Young noté $E_2$, le deuxième substrat présentant une épaisseur notée $h_2$, le deuxième substrat présentant une forme initiale au repos ; c) incurver le premier substrat et le deuxième substrat de sorte qu'ils présentent chacun une forme arquée d'un rayon de courbure noté R sensiblement identique ; d) assembler le deuxième substrat à la couche active de sorte que le deuxième substrat épouse la forme du premier substrat ;

e) rétablir la forme initiale au repos du deuxième substrat de sorte que la couche active présente l'état de contrainte final, le procédé étant remarquable en ce que le deuxième matériau du deuxième substrat est un matériau souple vérifiant la relation $E_2/E_1 < 10^{-2}$, en ce que l'épaisseur du deuxième substrat vérifie la relation $h_2/h_1 \geq 10^4$, et en ce que le rayon de courbure vérifie la relation $R = \frac{h_2}{2\varepsilon}$.

Ainsi, la demanderesse a constaté de manière surprenante que l'épaisseur du deuxième substrat joue un rôle plus important que sa raideur afin d'augmenter le moment de torsion lors de l'étape c). C'est pourquoi l'épaisseur du deuxième substrat vérifie la relation $h_2/h_1 \geq 10^4$. Le deuxième substrat doit alors autoriser une courbure prédéterminée pour une telle épaisseur. C'est pourquoi le deuxième matériau est un matériau souple vérifiant la relation $E_2/E_1 < 10^{-2}$. La courbure est prédéterminée selon la relation $R = \frac{h_2}{2\varepsilon}$, l'état de contrainte final $\varepsilon$ étant caractérisé par le niveau de contrainte (et donc la déformation) souhaité.

Par ailleurs, il est à noter que les étapes c) et d) peuvent être interverties. Lorsque l'étape d) est exécutée avant l'étape c), alors l'étape c) consiste à incurver simultanément le premier substrat et le deuxième substrat de sorte qu'ils présentent chacun une forme arquée d'un rayon de courbure noté R sensiblement identique. Lorsque l'étape d) est exécutée après l'étape c), alors l'étape c) consiste à incurver séparément le premier substrat et le deuxième substrat de sorte qu'ils présentent chacun une forme arquée d'un rayon de courbure noté R sensiblement identique. L'étape d) consiste alors à assembler le deuxième substrat à la couche active de sorte que le deuxième substrat épouse la forme arquée du premier substrat.

Lorsque l'état de contrainte initial est celui d'une tension, on obtient un état de contrainte final relaxé (c'est-à-dire $\varepsilon=0$) par l'intermédiaire de l'étape c) qui est exécutée de sorte que le rayon de courbure est négatif c'est-à-dire que la surface libre de la couche active est concave.

Lorsque l'état de contrainte initial est un état contraint en compression, on obtient un état de contrainte final relaxé par l'intermédiaire de l'étape c) qui est exécutée de sorte que le rayon de courbure est positif c'est-à-dire que la surface libre de la couche active est convexe.

Lorsque l'état de contrainte initial est un état relaxé, on obtient un état de contrainte final en tension par l'intermédiaire de l'étape c) qui est exécutée de sorte que le rayon de courbure est positif c'est-à-dire que la surface libre de la couche active est convexe.

Lorsque l'état de contrainte initial est un état relaxé, on obtient un état de contrainte final en compression par l'intermédiaire de l'étape c) qui est exécutée de sorte que, le rayon de courbure est négatif c'est-à-dire que la surface libre de la couche active est concave. Toutefois, ce passage peut s'accompagner d'un gauchissement de la couche active (*buckling* en langue anglaise) si le niveau de contrainte est trop important.

Selon un mode de mise en oeuvre, le premier substrat comporte une première partie formant la couche active et une seconde partie, et le procédé comporte une étape d1) consistant à réduire l'épaisseur de la seconde partie du premier substrat.

Selon une forme d'exécution, l'étape d1) est exécutée de manière à maintenir le premier substrat autoporté, l'étape d1) étant exécutée avant l'étape c).

Ainsi, un tel premier substrat autoporté permet à la fois d'autoriser une courbure importante lors de l'étape c) et de faciliter le transfert de la couche active sur le deuxième substrat.

Selon une variante d'exécution, l'étape d1) est exécutée de manière à supprimer sensiblement la totalité de la seconde partie du premier substrat, l'étape d1) étant exécutée après l'étape d) et avant l'étape e).

Ainsi, l'énergie liée au niveau de contrainte est concentrée sur la couche active.

Avantageusement, le deuxième substrat comporte deux portions d'extrémité latérales, et le procédé comporte une étape c1) consistant à ménager au moins un organe de renforcement dans chaque portion d'extrémité latérale, chaque organe de renforcement étant de préférence réalisé sous la forme d'une aiguille.

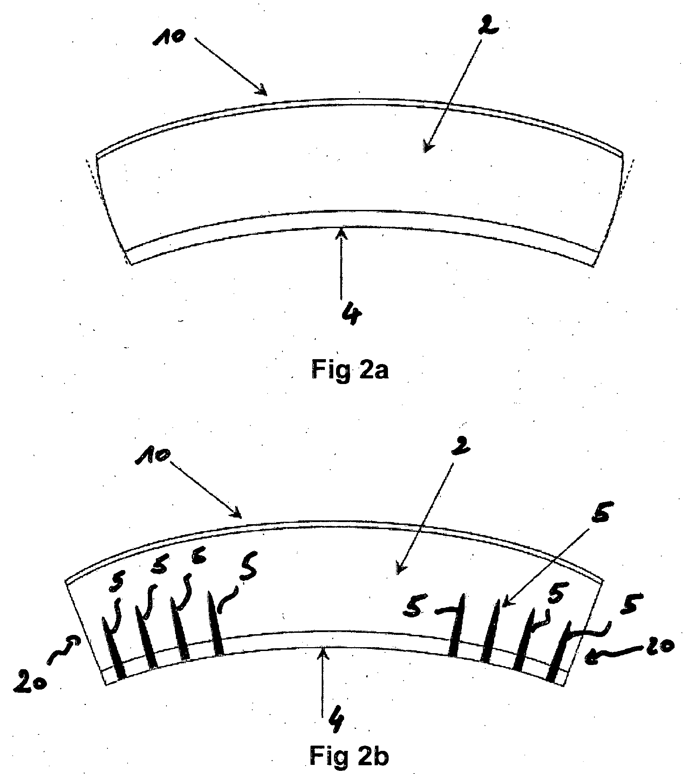

Il a été constaté des phénomènes de bord (illustrés à la figure 2a) c'est-à-dire des pertes d'efficacité en terme de niveau de contrainte dans les portions d'extrémité latérales de la couche active. Ainsi, une telle étape c1) permet de s'affranchir de ce problème en renforçant localement les portions d'extrémité latérales du deuxième substrat. Par ailleurs la forme d'aiguille est particulièrement adaptée afin d'obtenir un renforcement mécanique tout en conservant une grande souplesse du deuxième matériau du deuxième substrat.

Avantageusement, le procédé comporte une étape c2) consistant à assembler une couche formant raidisseur au deuxième substrat, l'étape c2) étant exécutée avant l'étape c).

Ainsi, le deuxième substrat en conjugaison avec la couche formant raidisseur définissent un substrat composite permettant d'obtenir un niveau de contrainte élevé sans défauts quand bien même l'épaisseur $h_1$ de la couche active est importante. La couche formant raidisseur agit comme une contre-plaque qui permet de compenser la déformation de la couche utile.

Selon une forme d'exécution, chaque organe de renforcement s'étend à partir de la couche formant raidisseur.

Ainsi, la mise en place des organes de renforcement dans le deuxième substrat s'effectue aisément par l'intermédiaire de la couche formant raidisseur.

Préférentiellement, le deuxième matériau du deuxième substrat vérifie la relation $E_2/E_1 \leq 10^{-3}$, et l'épaisseur du deuxième substrat vérifie la relation $h_2/h_1$

$\geq 10^5$.

Encore préférentiellement, le deuxième matériau du deuxième substrat vérifie la relation $E_2/E_1 \leq 10^{-4}$, et l'épaisseur du deuxième substrat vérifie la relation $h_2/h_1 \geq 10^6$.

Ainsi, la vérification de ces relations mathématiques permet d'obtenir des niveaux de contrainte importants dans la couche active, et ce avec une absence de défauts, l'augmentation de l'épaisseur du deuxième substrat relativement au premier substrat étant conjuguée avec une augmentation de la souplesse du deuxième substrat relativement au premier substrat.

Selon une forme d'exécution, l'épaisseur de la couche active est comprise entre 5 nm et 50 nm, de préférence comprise entre 5 nm et 35 nm, et en ce que l'épaisseur du deuxième substrat est comprise entre 1 cm et 10 cm.

Selon une forme d'exécution, le rayon de courbure est compris entre 0,5 m et 2 m en valeur absolue.

Selon un mode de mise en oeuvre, le deuxième matériau du deuxième substrat est un élastomère, de préférence sélectionné dans le groupe comportant le polydiméthylsiloxane, le polyméthacrylate de méthyle, les polyamides tels que le PA 6-3-T et le polytétrafluoroéthylène.

Ainsi, le choix d'un élastomère permet d'obtenir plus aisément une une déformation supérieure à 0,75 %, voire supérieure à 1%, de la couche active sans création de défauts car un tel choix permet d'augmenter considérablement l'épaisseur du deuxième substrat relativement à la couche active, par exemple $h_2/h_1 \geq 10^6$, grâce à une augmentation importante de la souplesse du deuxième matériau du deuxième substrat (faible module d'Young d'un élastomère) relativement au premier matériau du premier substrat, par exemple $E_2/E_1 \leq 10^{-4}$. Or, comme il a été dit précédemment, l'épaisseur du deuxième substrat est un paramètre crucial pour augmenter le moment de torsion lors de l'étape c).

Selon une caractéristique, le premier matériau de la couche active est un matériau semi-conducteur, de préférence sélectionné dans le groupe comportant Si, Ge, les matériaux IV-IV tels que Si-Ge, les matériaux III-V tels que GaN, GaAs, InP, InGaAs, les matériaux II-VI.

Avantageusement, le premier matériau de la couche active est un matériau piézoélectrique, de préférence sélectionné dans le groupe comportant le titano-zirconate de plomb, ZnO, GaN, AlN, le quartz, LiNbO$_3$, LiTaO$_3$, BaTiO$_3$, la tourmaline.

Ainsi, un tel premier matériau permet de s'affranchir du problème du gauchissement de la couche active lorsque l'état de contrainte initial est un état relaxé, et lorsque l'on souhaite obtenir un état de contrainte final en compression. En effet, si le premier matériau est préalablement contraint en compression de manière statique, le premier matériau accepte sans rompre des oscillations mécaniques avec une amplitude accrue. L'efficacité de la transduction piézoélectrique est également améliorée. En outre, la contrainte en compression accompagnée d'un gauchissement de la couche active permet d'accroître de nouveau l'amplitude des oscillations mécaniques et l'efficacité de la transduction piézoélectrique.

Selon une forme d'exécution, le premier matériau de la couche active est un polymère, de préférence un polymère semi-conducteur, encore préférentiellement un polymère semi-conducteur organique.

Ainsi, un tel premier matériau est plus aisé à contraindre qu'un matériau rigide de par un module d'Young plus faible. En outre, un tel premier matériau peut être contraint à une épaisseur nettement supérieure relativement à un matériau rigide.

Selon une autre forme d'exécution, le premier matériau de la couche active est un matériau ferromagnétique.

Ainsi, un tel premier matériau est particulièrement adapté pour une application en spintronique. La modification de l'état de contrainte de la couche active permet de modifier le cycle d'hystérésis.

Selon une autre forme d'exécution, le premier matériau de la couche active est un matériau optique non linéaire.

Ainsi, un tel premier matériau peut être particulièrement adapté à la génération de seconde harmonique.

Selon une autre forme d'exécution, le premier matériau de la couche active est un matériau pyroélectrique.

Selon un mode de mise en oeuvre, le procédé comporte une étape f) consistant à transférer la couche active sur un substrat final puis comporte une étape g) consistant à supprimer le deuxième substrat..

Ainsi, le deuxième substrat forme un substrat temporaire employé uniquement pour la modification de l'état de contrainte. Le substrat final est choisi selon l'application envisagée pour la couche active.

La présente invention se rapporte également à une structure pour la modification d'un état de contrainte initial d'une couche dite active vers un état de contrainte final noté ε, la structure comportant :

- un substrat,
- la couche active surmontant le substrat,

la couche active étant réalisée dans un premier matériau présentant un module d'Young noté $E_1$, la couche active présentant une épaisseur notée $h_1$. le substrat étant réalisé dans un deuxième matériau présentant un module d'Young noté $E_2$, le substrat présentant une épaisseur notée $h_2$, le substrat et la couche active présentant une forme arquée d'un rayon de courbure noté R, la structure étant remarquable en ce que le deuxième matériau du substrat est un matériau souple vérifiant la relation $E_2/E_1 < 10^{-2}$, en ce que l'épaisseur du substrat vérifie la relation $h_2/h_1 \geq 10^4$, et en ce que le rayon de courbure vérifie la relation $R = \frac{h_2}{2\varepsilon}$.

Ainsi, comme précisé précédemment, la demanderesse a constaté de manière surprenante que l'épaisseur du substrat joue un rôle plus important que sa raideur afin d'augmenter le moment de torsion afin que la couche active présente la forme arquée souhaitée. C'est pourquoi l'épaisseur du substrat vérifie la relation $h_2/h_1 \geq 10^4$. Le substrat doit alors autoriser une courbure prédéterminée pour une telle épaisseur. C'est pourquoi le deuxième matériau est un matériau souple vérifiant la relation $E_2/E_1 < 10^{-2}$. La courbure est prédéterminée selon la relation $R = \frac{h_2}{2\varepsilon}$, l'état de contrainte final $\varepsilon$ étant caractérisé par le niveau de contrainte (et donc la déformation) souhaité.

Dans un mode de réalisation, le substrat comporte deux portions d'extrémité latérales, et la structure comporte au moins un organe de renforcement ménagé dans chaque portion d'extrémité latérale, chaque organe de renforcement étant de préférence réalisé sous la forme d'une aiguille.

Ainsi, il a été constaté des phénomènes de bord (illustrés à la figure 2a) c'est-à-dire des pertes d'efficacité en terme de niveau de contrainte dans les portions d'extrémité latérales de la couche active. Ainsi, une telle structure permet de s'affranchir de ce problème en renforçant localement les portions d'extrémité latérales du substrat. Par ailleurs la forme d'aiguille est particulièrement adaptée afin d'obtenir un renforcement mécanique tout en conservant une grande souplesse du deuxième matériau du substrat.

Avantageusement, la structure comporte une couche formant raidisseur assemblée au substrat.

Ainsi, le substrat en conjugaison avec la couche formant raidisseur définissent un substrat composite permettant d'obtenir un niveau de contrainte élevé sans défauts quand bien même l'épaisseur $h_1$ de la couche active est importante. La couche formant raidisseur agit comme une contre-plaque qui permet de compenser la déformation de la couche utile.

Selon une forme d'exécution, chaque organe de renforcement s'étend à partir de la couche formant raidisseur.

Ainsi, la mise en place des organes de renforcement dans le deuxième substrat s'effectue aisément par l'intermédiaire de la couche formant raidisseur.

Selon une forme d'exécution, le deuxième matériau du substrat est un élastomère, de préférence sélectionné dans le groupe comportant le polydiméthylsiloxane, le polyméthacrylate de méthyle, les polyamides tels que le PA 6-3-T et le polytétrafluoroéthylène.

Ainsi, le choix d'un élastomère permet d'obtenir plus aisément une une déformation supérieure à 0,75 %, voire supérieure à 1%, de la couche active sans création de défauts car un tel choix permet d'augmenter considérablement l'épaisseur du substrat relativement à la couche active, par exemple $h_2/h_1 \geq 10^6$, grâce à une augmentation importante de la souplesse du deuxième matériau du substrat (faible module d'Young d'un élastomère) relativement au premier matériau de la couche active, par exemple $E_2/E_1 \leq 10^{-4}$. Or, comme il a été dit précédemment, l'épaisseur du substrat est un paramètre crucial pour augmenter le moment de torsion afin que la couche active présente la forme arquée souhaitée.

Selon une forme d'exécution, le premier matériau de la couche active est un matériau semi-conducteur, de préférence sélectionné dans le groupe comportant Si, Ge, les matériaux IV-IV tels que Si-Ge, les matériaux III-V tels que GaN, GaAs, InP, InGaAs, les matériaux II-VI.

Avantageusement, le premier matériau de la couche active est un matériau piézoélectrique, de préférence sélectionné dans le groupe comportant le titanozirconate de plomb, ZnO, GaN, AlN, le quartz, LiNbO₃, LiTaO₃, BaTiO₃, la tourmaline.

Ainsi, un tel premier matériau permet de s'affranchir du problème du gauchissement de la couche active lorsque l'état de contrainte initial est un état relaxé, et lorsque l'on souhaite obtenir un état de contrainte final en compression. En effet, si le premier matériau est préalablement contraint en compression de manière statique, le premier matériau accepte sans rompre des oscillations mécaniques avec une amplitude accrue. L'efficacité de la transduction piézoélectrique est également améliorée. En outre, la contrainte en compression accompagnée d'un gauchissement de la couche active permet d'accroître de nouveau l'amplitude des oscillations mécaniques et l'efficacité de la transduction piézoélectrique.

Selon une forme d'exécution, le premier matériau de la couche active est un polymère, de préférence un polymère semi-conducteur, encore préférentiellement un polymère semi-conducteur organique.

Ainsi, un tel premier matériau est plus aisé à contraindre qu'un matériau rigide de par un module d'Young plus faible. En outre, un tel premier matériau peut être contraint à une épaisseur nettement supérieure relativement à un matériau rigide.

Selon une autre forme d'exécution, le premier matériau de la couche active est un matériau ferromagnétique.

Ainsi, un tel premier matériau est particulièrement adapté pour une application en spintronique. La modification de l'état de contrainte de la couche active permet de modifier le cycle d'hystérésis.

Selon une autre forme d'exécution, le premier matériau de la couche active est un matériau optique non linéaire.

Ainsi, un tel premier matériau peut être particulièrement adapté à la génération de seconde harmonique.

Selon une autre forme d'exécution, le premier matériau de la couche active est un matériau pyroélectrique.

D'autres caractéristiques et avantages apparaîtront dans la description qui va suivre de modes de mise en oeuvre d'un procédé selon l'invention, donnés à titre d'exemples non limitatifs, en référence aux dessins annexés dans lesquels :

-   les figures 1a à 1g sont des vues en coupe transversale illustrant les différentes étapes d'un premier mode de mise en oeuvre d'un procédé selon l'invention,
-   les figures 2a et 2b sont des vues en coupe transversale illustrant des variantes de mise en oeuvre d'un procédé selon l'invention,
-   la figure 3 est un graphique représentant en abscisse $h_1/h_2$ et en ordonnée $E_1/E_2$ illustrant une plage de fonctionnement pour mettre en oeuvre un procédé selon l'invention.

Pour les différents modes de mise en oeuvre, les mêmes références seront utilisées pour des éléments identiques ou assurant la même fonction, par souci de simplification de la description.

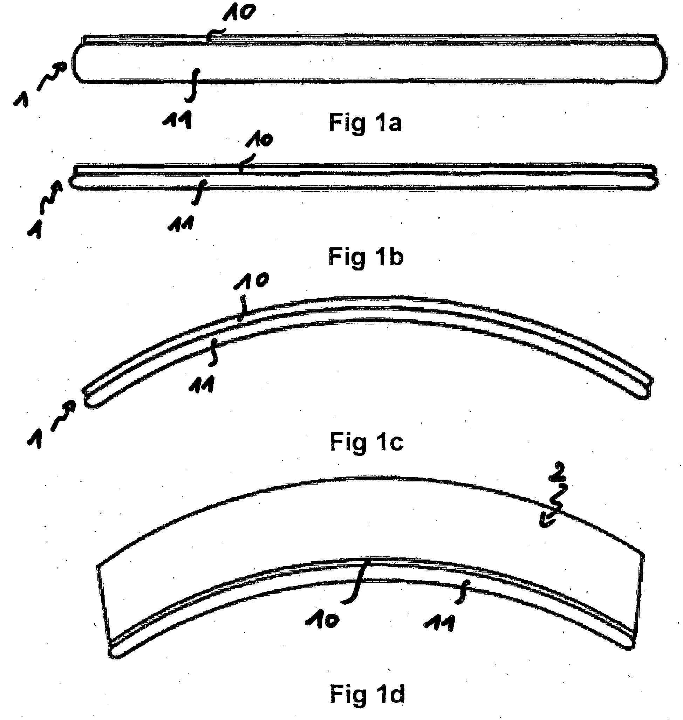

Le procédé illustré aux figures 1a à 1g est un procédé de modification d'un état de contrainte initial d'une couche active 10 vers un état de contrainte final, noté $\varepsilon$. A titre d'exemple non limitatif, l'état de contrainte initial de la couche active 10 est un état relaxé.

Le procédé comporte l'étape a) consistant à fournir un premier substrat 1 comprenant la couche active 10 dans l'état de contrainte initial (illustré à la figure 1a), la couche active 10 étant réalisée dans un premier matériau présentant un module d'Young noté $E_1$, la couche active 10 présentant une épaisseur notée $h_1$. Le premier matériau de la couche active 10 peut être un matériau semi-conducteur, de préférence sélectionné dans le groupe comportant Si, Ge, les matériaux IV-IV tels que Si-Ge, les matériaux III-V tels que GaN, GaAs, InP, In-GaAs, et les matériaux II-VI. A titre d'exemple non limitatif, l'épaisseur de la couche active est comprise entre 5 nm et 50 nm, de préférence comprise entre 5 nm et 35 nm. Par ailleurs, le module d'Young du silicium est de l'ordre de 160 GPa.

Le premier substrat 1 comporte une première partie formant la couche active 10 et une seconde partie 11. Le procédé comporte une étape d1) consistant à réduire l'épaisseur de la seconde partie 11 du premier substrat 1. Plus précisément, comme illustré à la figure 1b, l'étape d1) est exécutée de manière à maintenir le premier substrat 1 autoporté. L'étape d1) peut être exécutée mécaniquement notamment par meulage (*grinding* en langue anglaise) ou encore chimiquement par gravure.

Le procédé comporte l'étape b) consistant à fournir un deuxième substrat 2 réalisé dans un deuxième matériau présentant un module d'Young noté $E_2$, le deuxième substrat 2 présentant une épaisseur notée $h_2$, le deuxième substrat 2 présentant une forme initiale au repos. Le deuxième matériau du deuxième substrat 2 est un matériau souple vérifiant la relation $E_2/E_1, < 10^{-2}$.

L'épaisseur du deuxième substrat 2 vérifie la relation $h_2/h_1 \geq 10^4$. Le rayon de courbure vérifie la relation $R = \frac{h_2}{2\varepsilon}$. Plus précisément, le deuxième matériau du deuxième substrat 2 peut être un élastomère, de préférence sélectionné dans le groupe comportant le polydiméthylsiloxane (PDMS), le polyméthacrylate de méthyle, les polyamides tels que le PA 6-3-T et le polytétrafluoroéthylène. Par ailleurs, le module d'Young du PDMS est de l'ordre de 7,1 MPa. A titre d'exemple non limitatif, l'épaisseur du deuxième substrat 2 est comprise entre 1 cm et 10 cm.

Le procédé comporte l'étape c) consistant à incurver le premier substrat 1 (illustré à la figure 1c) et le deuxième substrat 2 de sorte qu'ils présentent chacun une forme arquée d'un rayon de courbure sensiblement identique. Le rayon de courbure peut être compris entre 0,5 m et 2 m. L'étape c) peut être exécutée par l'intermédiaire d'un moule cylindrique arqué. La couche active 10 présente alors un état de contrainte intermédiaire, légèrement contraint en tension.

Le procédé comporte l'étape d) consistant à assembler le deuxième substrat 2 à la couche active 10 (illustré à la figure 1d) de sorte que le deuxième substrat 2 épouse la forme arquée du premier substrat 1. L'étape d) peut être exécutée de manière à obtenir un collage direct du deuxième substrat 2 à la couche active 10 à l'aide d'un nettoyage adapté connu de l'homme du métier.

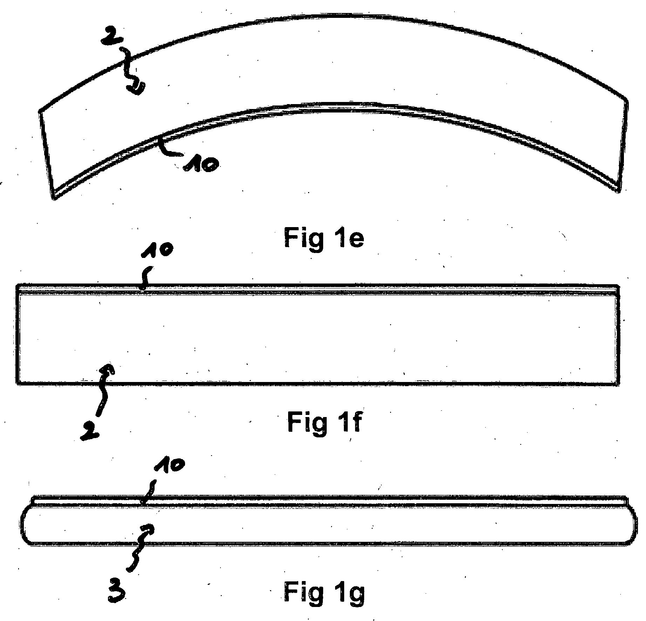

Après l'étape d), la seconde partie 11 du premier substrat 1 est supprimée (illustré à la figure 1e), par exemple par gravure. Ainsi, une structure selon l'invention est illustrée à la figure 1e. La structure comporte donc :

-   le deuxième substrat 2,
-   la couche active 10 surmontant le deuxième substrat 2,

Le procédé comporte l'étape e) consistant à rétablir la forme initiale au repos du deuxième substrat 2 (illustré à la figure 1f) de sorte que la couche active 10 présente l'état de contrainte final, fortement contraint en tension.

Comme illustré à la figure 1g, le procédé comporte une étape f) consistant à transférer la couche active 10 sur un substrat final 3 puis comporte une étape g) consistant à supprimer le deuxième substrat 2. Bien entendu, le matériau dans lequel est réalisé le substrat final 3 doit présenter un module d'Young adapté de, sorte qu'il maintient le niveau de contrainte obtenue lors de l'étape e). L'étape g) peut être exécutée par délamination.

Dans le mode de mise en oeuvre illustré à la figure 2a, le procédé diffère du procédé illustré aux figures 1a à 1g en ce qu'il comporte une étape c2) consistant à assembler une couche formant raidisseur 4 au deuxième substrat 2, l'étape c2) étant exécutée avant l'étape c).

Dans le mode de mise en oeuvre illustré à la figure 2b, le procédé diffère du procédé illustré à la figure 2a en ce que le procédé comporte une étape c1) consistant à ménager au moins un organe de renforcement 5 dans chaque portion d'extrémité latérale 20 du deuxième substrat 2, chaque organe de renforcement 5 étant réalisé sous la forme d'une aiguille. En outre, chaque organe de renforcement 5 s'étend à partir de la couche formant raidisseur 4. Ainsi, une structure selon l'invention est illustrée à la figure 2b. La structure comporte donc :

- le deuxième substrat 2 comportant deux portions d'extrémité latérales 20,
- la couche active 10 surmontant le deuxième substrat 2,
- une couche formant raidisseur 4 assemblée au substrat 2,
- des organes de renforcement 5 en forme d'aiguille ménagés dans chaque portion d'extrémité latérale 20, chaque organe de renforcement 5 s'étendant à partir de la couche formant raidisseur 4.

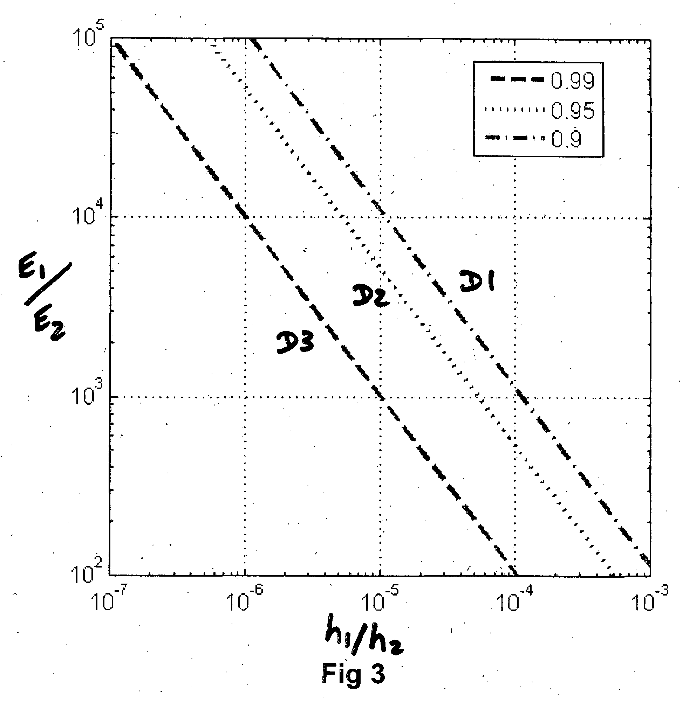

En ce qui concerne le graphique illustré à la figure 3, le modèle développé dans le document D1 avec les hypothèses $E_2 \ll E_1$ et $h_2 \gg h_1$ conduit aux équations suivantes :

$$\varepsilon = \frac{h_2}{2R} F$$

$$F = \frac{1 + 2\left(h_1/h_2\right) + E_1/E_2 \left(h_1/h_2\right)^2}{1 + E_1/E_2 \left(h_1/h_2\right)}$$

F peut être défini comme un facteur de qualité qui traduit l'efficacité de mise sous contrainte. Le graphique illustré à la figure 3 représente trois droites D1, D2, D3 correspondant respectivement à trois valeurs de F : 0,9 ; 0,95 et 0,99. Lorsque F est proche de 1 (par exemple pour la droite D3 correspondant à F=0,99) alors $\varepsilon \approx \frac{h_2}{2R}$.

Ainsi, la partie délimitée au-dessous la droite D3 correspondant à F=0,99 définit une plage de fonctionnement du procédé.

A titre d'exemples non limitatifs, le deuxième matériau du deuxième substrat 2 peut vérifier la relation $E_2/E_1 \le 10^{-3}$, et l'épaisseur du deuxième substrat 2 peut vérifier la relation $h_2/h_1 \ge 10^5$. De même, le deuxième matériau du deuxième substrat 2 peut vérifier la relation $E_2/E_1 \le 10^{-4}$, et l'épaisseur du deuxième substrat 2 peut vérifier la relation $h_2/h_1 \ge 10^6$.

Bien entendu, les modes de mise en oeuvre de l'invention décrits ci-dessus ne présentent aucun caractère limitatif. Des détails et améliorations peuvent y être apportés dans d'autres variantes d'exécution sans pour autant sortir du cadre de l'invention.

**Revendications**

1. Procédé de modification d'un état de contrainte initial d'une couche dite active (10) vers un état de contrainte final noté ε, le procédé comportant les étapes :

   a) fournir un premier substrat (1) comprenant la couche active (10) dans l'état de contrainte initial, la couche active (10) étant réalisée dans un premier matériau présentant un module d'Young noté $E_1$, la couche active (10) présentant une épaisseur notée $h_1$ ;
   b) fournir un deuxième substrat (2) réalisé dans un deuxième matériau présentant un module d'Young noté $E_2$, le deuxième substrat (2) présentant une épaisseur notée $h_2$, le deuxième substrat (2) présentant une forme initiale au repos ;
   c) incurver le premier substrat (1) et le deuxième substrat (2) de sorte qu'ils présentent chacun une forme arquée d'un rayon de courbure noté R sensiblement identique ;
   d) assembler le deuxième substrat (2) à la couche active (10) de sorte que le deuxième substrat (2) épouse la forme du premier substrat ;
   e) rétablir la forme initiale au repos du deuxième substrat (2) de sorte que la couche active (10) présente l'état de contrainte final,

   dans lequel le deuxième matériau du deuxième substrat (2) est un matériau souple vérifiant la relation $E_2 / E_1 < 10^{-2}$, et
   dans lequel le rayon de courbure vérifie la relation R = $h_2 / 2\varepsilon$,
   **caractérisé en ce que**
   l'épaisseur du deuxième substrat (2) vérifie la relation $h_2 / h_1 \ge 10^4$.

2. Procédé selon la revendication 1, **caractérisé en ce que** le premier substrat (1) comporte une première partie formant la couche active (10) et une seconde partie (11), et **en ce que** le procédé comporte une étape d1) consistant à réduire l'épaisseur de la seconde partie (11) du premier substrat (1).

3. Procédé selon la revendication 2, **caractérisé en ce que** l'étape d1) est exécutée de manière à maintenir le premier substrat (1) autoporté, l'étape d1) étant exécutée avant l'étape c).

4. Procédé selon la revendication 2, **caractérisé en ce**

**que** l'étape d1) est exécutée de manière à supprimer sensiblement la totalité de la seconde partie (11) du premier substrat (1), l'étape d1) étant exécutée après l'étape d) et avant l'étape e).

5. Procédé selon l'une des revendications 1 à 4, **caractérisé en ce que** le deuxième substrat (2) comporte deux portions d'extrémité latérales (20), et **en ce que** le procédé comporte une étape c1) consistant à ménager au moins un organe de renforcement (5) dans chaque portion d'extrémité latérale (20), chaque organe de renforcement (5) étant de préférence réalisé sous la forme d'une aiguille.

6. Procédé selon l'une des revendications 1 à 5, **caractérisé en ce qu'**il comporte une étape c2) consistant à assembler une couche formant raidisseur (4) au deuxième substrat (2), l'étape c2) étant exécutée avant l'étape c).

7. Procédé selon la revendication 6 en combinaison avec la revendication 5, **caractérisé en ce que** chaque organe de renforcement (5) s'étend à partir de la couche formant raidisseur (4).

8. Procédé selon l'une des revendications 1 à 7, **caractérisé en ce que** le deuxième matériau du deuxième substrat (2) vérifie la relation $E_2 / E_1 \leq 10^{-3}$, et **en ce que** l'épaisseur du deuxième substrat (2) vérifie la relation $h_2 / h_1 \geq 10^5$.

9. Procédé selon l'une des revendications 1 à 8, **caractérisé en ce que** le deuxième matériau du deuxième substrat (2) vérifie la relation $E_2 / E_1 \leq 10^{-4}$, et **en ce que** l'épaisseur du deuxième substrat (2) vérifie la relation $h_2 / h_1 \geq 10^6$.

10. Procédé selon l'une des revendications 1 à 9, **caractérisé en ce que** l'épaisseur de la couche active (10) est comprise entre 5 nm et 50 nm, de préférence comprise entre 5 nm et 35 nm, et **en ce que** l'épaisseur du deuxième substrat (2) est comprise entre 1 cm et 10 cm.

11. Procédé selon l'une des revendications 1 à 10, **caractérisé en ce que** le rayon de courbure est compris entre 0,5 m et 2 m en valeur absolue.

12. Procédé selon l'une des revendications 1 à 11, **caractérisé en ce que** le deuxième matériau du deuxième substrat (2) est un élastomère, de préférence sélectionné dans le groupe comportant le polydiméthylsiloxane, le polyméthacrylate de méthyle, les polyamides tels que le PA 6-3-T et le polytétrafluoroéthylène.

13. Procédé selon l'une des revendications 1 à 12, **caractérisé en ce que** le premier matériau de la couche active (10) est un matériau semi-conducteur, de préférence sélectionné dans le groupe comportant Si, Ge, les matériaux IV-IV tels que Si-Ge, les matériaux III-V tels que GaN, GaAs, InP, InGaAs, les matériaux II-VI.

14. Procédé selon l'une des revendications 1 à 12, **caractérisé en ce que** le premier matériau de la couche active (10) est un matériau piézoélectrique, de préférence sélectionné dans le groupe comportant le titano-zirconate de plomb, ZnO, GaN, AlN , le quartz, $LiNbO_3$, $LiTaO_3$, $BaTiO_3$, la tourmaline.

15. Procédé selon l'une des revendications 1 à 14, **caractérisé en ce qu'**il comporte une étape f) consistant à transférer la couche active (10) sur un substrat final (3) puis comporte une étape g) consistant à supprimer le deuxième substrat (2).

16. Structure pour la modification d'un état de contrainte initial d'une couche dite active (10) vers un état de contrainte final noté ε, la structure comportant :

 - un substrat (2),
 - la couche active (10) surmontant le substrat (2),

 la couche active (10) étant réalisée dans un premier matériau présentant un module d'Young noté $E_1$, la couche active (10) présentant une épaisseur notée $h_1$, le substrat (2) étant réalisé dans un deuxième matériau présentant un module d'Young noté $E_2$, le substrat (2) présentant une épaisseur notée $h_2$, le substrat (2) et la couche active (10) présentant une forme arquée d'un rayon de courbure noté R, dans laquelle le deuxième matériau du substrat (2) est un matériau souple vérifiant la relation $E_2 / E_1 < 10^{-2}$, et dans laquelle le rayon de courbure vérifie la relation $R = h_2 / 2\varepsilon$, **caractérisée en ce que** l'épaisseur du substrat (2) vérifie la relation $h_2 / h_1 \geq 10^4$.

17. Structure selon la revendication 16, **caractérisée en ce que** le substrat (2) comporte deux portions d'extrémité latérales (20), et **en ce que** la structure comporte au moins un organe de renforcement (5) ménagé dans chaque portion d'extrémité latérale (20), chaque organe de renforcement (5) étant de préférence réalisé sous la forme d'une aiguille.

18. Structure selon la revendication 16 ou 17, **caractérisée en ce qu'**elle comporte une couche formant raidisseur (4) assemblée au substrat (2).

19. Structure selon la revendication 18 en combinaison avec la revendication 17, **caractérisée en ce que** chaque organe de renforcement (5) s'étend à partir de la couche formant raidisseur (4).

20. Structure selon l'une des revendications 16 à 19, **caractérisée en ce que** le deuxième matériau du substrat (2) est un élastomère, de préférence sélectionné dans le groupe comportant le polydiméthylsiloxane, le polyméthacrylate de méthyle, les polyamides tels que le PA 6-3-T et le polytétrafluoroéthylène.

21. Structure selon l'une des revendications 16 à 20, **caractérisée en ce que** le premier matériau de la couche active (10) est un matériau semiconducteur, de préférence sélectionné dans le groupe comportant Si, Ge, les matériaux IV-IV tels que Si-Ge, les matériaux III-V tels que GaN, GaAs, InP, InGaAs, les matériaux II-VI.

22. Structure selon l'une des revendications 16 à 20, **caractérisée en ce que** le premier matériau de la couche active (10) est un matériau piézoélectrique, de préférence sélectionné dans le groupe comportant le titano-zirconate de plomb, ZnO, GaN, AIN , le quartz, $LiNbO_3$, $LiTaO_3$, $BaTiO_3$, la tourmaline.

**Patentansprüche**

1. Verfahren zur Modifizierung eines anfänglichen Spannungszustands einer sogenannten aktiven Schicht (10) in einen mit e bezeichneten endgültigen Spannungszustand, wobei das Verfahren die folgenden Schritte umfasst:

a) Bereitstellen eines ersten Substrats (1) mit der aktiven Schicht (10) im anfänglichen Spannungszustand, wobei die aktive Schicht (10) aus einem ersten Material mit einem mit $E_1$ bezeichneten Young-Modul realisiert ist, die aktive Schicht (10) eine mit $h_1$ bezeichnete Dicke hat;
b) Bereitstellen eines zweiten Substrats (2), hergestellt aus einem zweiten Material mit einem mit $E_2$ bezeichneten Young-Modul, wobei das zweite Substrat (2) eine mit $h_2$ bezeichnete Dicke aufweist, das zweite Substrat (2) eine anfängliche Ruhezustandsform aufweist;
c) das erste Substrat (1) und das zweite Substrat (2) so zu biegen, dass jedes von ihnen eine im Wesentlichen gleiche gebogene Form mit einem mit R bezeichneten Krümmungsradius aufweist;
d) Anfügen des zweiten Substrats (2) an die aktive Schicht (10), derart dass das zweite Substrat (2) die Form des ersten Substrats annimmt;
e) Wiederherstellen der anfänglichen Form des zweiten Substrats (2), so dass die aktive Schicht (10) den endgültigen Spannungszustand aufweist,

bei dem das zweite Material des zweiten Substrats (2) ein nachgiebiges, die Relation $E_2 / E_1 < 10^{-2}$ erfüllendes Material ist, und
bei dem der Krümmungsradius die Relation $R = h_2/2\varepsilon$ erfüllt,
**dadurch gekennzeichnet, dass**
die Dicke des zweiten Substrats (2) die Relation $h_2 / h_1 \geq 10^4$ erfüllt.

2. Verfahren nach Anspruch 1, **dadurch gekennzeichnet, dass** das erste Substrat (1) einen die aktive Schicht (10) bildenden ersten Teil und einen zweiten Teil (11) umfasst, und dadurch, dass das Verfahren einen Schritt d1) umfasst, darin bestehend, die Dicke des zweiten Teils (11) des ersten Substrats (1) zu reduzieren.

3. Verfahren nach Anspruch 2, **dadurch gekennzeichnet, dass** der Schritt d1) so ausgeführt wird, dass das erste Substrat (1) selbsttragend bleibt, wobei der Schritt d1) vor dem Schritt c) ausgeführt wird.

4. Verfahren nach Anspruch 2, **dadurch gekennzeichnet, dass** der Schritt d1) so ausgeführt wird, dass der zweite Teil (11) des ersten Substrats (1) im Wesentlichen ganz beseitigt wird, wobei der Schritt d1) nach dem Schritt d) und vor dem Schritt e) ausgeführt wird.

5. Verfahren nach einem der Ansprüche 1 bis 4, **dadurch gekennzeichnet, dass** das zweite Substrat (2) zwei seitliche Endteile (20) umfasst, und dadurch, dass das Verfahren einen Schritt c1) umfasst, darin bestehend, wenigstens ein Verstärkungselement (5) in jedem seitlichen Endteil (20) anzubringen, wobei jedes Verstärkungsorgan (5) vorzugsweise in Form einer Nadel realisiert wird.

6. Verfahren nach einem der Ansprüche 1 bis 5, **dadurch gekennzeichnet, dass** es einen Schritt c2) umfasst, darin bestehend, dem zweiten Substrat (2) eine Versteifungsschicht (4) anzufügen, wobei der Schritt c2) vor dem Schritt c) ausgeführt wird.

7. Verfahren nach Anspruch 6 in Verbindung mit Anspruch 5, **dadurch gekennzeichnet, dass** jedes Verstärkungsorgan (5) sich ab der Versteifungsschicht (4) erstreckt.

8. Verfahren nach einem der Ansprüche 1 bis 7, **dadurch gekennzeichnet, dass** das zweite Material des zweiten Substrats (2) die Relation $E_2 / E_1 \leq 10^{-3}$ erfüllt, und dass die Dicke des zweiten Substrats (2) die Relation $h_2 / h_1 \geq 10^5$ erfüllt.

9. Verfahren nach einem der Ansprüche 1 bis 8, **da-**

**durch gekennzeichnet, dass** das zweite Material des zweiten Substrats (2) die Relation $E_2 / E_1 \leq 10^{-4}$ erfüllt, und dass die Dicke des zweiten Substrats (2) die Relation $h_2 / h_1 \geq 10^6$ erfüllt.

10. Verfahren nach einem der Ansprüche 1 bis 9, **dadurch gekennzeichnet, dass** die Dicke der aktiven Schicht (10) zwischen 5 nm und 50 nm, vorzugsweise zwischen 5 nm und 35 nm enthalten ist, und dadurch, dass die Dicke des zweiten Substrats (2) zwischen 1 cm und 10 cm enthalten ist.

11. Verfahren nach einem der Ansprüche 1 bis 10, **dadurch gekennzeichnet, dass** der Krümmungsradius zwischen 0,5 m und 2 m als Absolutwert enthalten ist.

12. Verfahren nach einem der Ansprüche 1 bis 11, **dadurch gekennzeichnet, dass** das zweite Material des zweiten Substrats (2) ein Elastomer ist, vorzugsweise gewählt aus der das Polydimethylsiloxan, das Polymethylmethacrylat, die Polyamide, wie zum Beispiel PA 6-3-T, und das Polytetrafluorethylen enthaltenden Gruppe.

13. Verfahren nach einem der Ansprüche 1 bis 12, **dadurch gekennzeichnet, dass** das erste Material der aktiven Schicht (10) ein halbleitendes Material ist, vorzugsweise gewählt aus der Si, Ge, die IV-IV-Materialien, wie zum Beispiel Si-Ge, die III-V-Materialien, wie zum Beispiel GaN, GaAs, InP, InGaAs, die II-VI-Materialien umfassenden Gruppe.

14. Verfahren nach einem der Ansprüche 1 bis 12, **dadurch gekennzeichnet, dass** das erste Material der aktiven Schicht (10) ein piezoelektrisches Material ist, vorzugsweise gewählt aus der das Blei-Zirkonat-Titanat, ZnO, GaN, AIN, das Quarz, $LiNbO_3$, $LiTaO_3$, $BaTiO_3$, das Turmalin enthaltenden Gruppe.

15. Verfahren nach einem der Ansprüche 1 bis 14, **dadurch gekennzeichnet, dass** es einen Schritt f) umfasst, darin bestehend, die aktive Schicht (10) auf ein endgültiges Substrat (3) zu transferieren, dann einen Schritt g) umfasst, darin bestehend, das zweite Substrat (2) zu beseitigen.

16. Struktur zur Modifizierung eines anfänglichen Spannungszustands einer sogenannten aktiven Schicht (10) in einen mit ε bezeichneten endgültigen Spannungszustand, wobei die Struktur umfasst:

   - ein Substrat (2),
   - die das Substrat (2) überdeckende aktive Schicht (10),

wobei die aktive Schicht (10) aus einem ersten Material hergestellt ist, das einen mit $E_1$ bezeichneten Young-Modul aufweist, die aktive Schicht (10) eine mit $h_1$ bezeichnete Dicke aufweist, das Substrat (2) aus einem zweiten Material hergestellt ist, das einen mit $E_2$ bezeichneten Young-Modul aufweist, das Substrat (2) eine mit $h_2$ bezeichnete Dicke aufweist, das Substrat (2) und die aktive Schicht (10) eine gebogene Form mit einem mit R bezeichneten Krümmungsradius aufweisen,
bei der das zweite Material des Substrats (2) ein die Relation $E_2 / E_1 < 10^{-2}$ erfüllendes Material ist, und bei der der Krümmungsradius die Relation $R = h_2/2\varepsilon$ erfüllt,
**dadurch gekennzeichnet, dass**
die Dicke des Substrats (2) die Relation $h_2 / h_1 \geq 10^4$ erfüllt.

17. Struktur nach Anspruch 16, **dadurch gekennzeichnet, dass** das Substrat (2) zwei seitliche Endteile (20) umfasst, und dadurch, dass die Struktur wenigstens ein Verstärkungselement (5) umfasst, vorgesehen in jedem seitlichen Endteil (20), wobei jedes Verstärkungsorgan (5) vorzugsweise in Form einer Nadel realisiert ist.

18. Struktur nach Anspruch 16 oder 17, **dadurch gekennzeichnet, dass** sie eine dem Substrat (2) hinzugefügte Versteifungsschicht (4) umfasst.

19. Struktur nach Anspruch 18 in Verbindung mit Anspruch 17, **dadurch gekennzeichnet, dass** sich jedes Verstärkungsorgan (5) ab der Versteifungsschicht (4) erstreckt.

20. Struktur nach einem der Ansprüche 16 bis 19, **dadurch gekennzeichnet, dass** das zweite Material des Substrats (2) ein Elastomer ist, vorzugsweise gewählt aus der das Polydimethylsiloxan, das Polymethylmethacrylat, die Polyamide wie zum Beispiel PA 6-3-T und das Polytetrafluorethylen enthaltenden Gruppe.

21. Struktur nach einem der Ansprüche 16 bis 20, **dadurch gekennzeichnet, dass** das erste Material der aktiven Schicht (10) ein halbleitendes Material ist, vorzugsweise gewählt aus der Si, Ge, die IV-IV-Materialien wie zum Beispiel Si-Ge, die III-V-Materialien wie zum Beispiel GaN, GaAs, InP, InGaAs, die II-VI-Materialien umfassenden Gruppe.

22. Struktur nach einem der Ansprüche 16 bis 20, **dadurch gekennzeichnet, dass** das erste Material der aktiven Schicht (10) ein piezoelektrisches Material ist, vorzugsweise gewählt aus der das Blei-Zirkonat-Titanat, ZnO, GaN, AIN, das Quarz, $LiNbO_3$, $LiTaO_3$, $BaTiO_3$, das Turmalin enthaltenden Gruppe.

## Claims

1. Method for modifying an initial strain state of what is referred to as an active layer (10) to a final strain state denoted ε, the method comprising the steps of:

   a) providing a first substrate (1) comprising the active layer (10) in the initial strain state, the active layer (10) being made of a first material having a Young's modulus denoted $E_1$, the active layer (10) having a thickness denoted $h_1$;
   b) providing a second substrate (2) made of a second material having a Young's modulus denoted $E_2$, the second substrate (2) having a thickness denoted $h_2$, the second substrate (2) having an initial shape at rest;
   c) bending the first substrate (1) and the second substrate (2) so that they each have a curved shape of substantially identical radius of curvature denoted R;
   d) joining the second substrate (2) to the active layer (10) so that the second substrate (2) closely follows the shape of the first substrate; and
   e) re-establishing the initial at-rest shape of the second substrate (2) so that the active layer (10) has the final strain state,

   wherein the second material of the second substrate (2) is a flexible material respecting the relationship $E_2 / E_1 < 10^{-2}$, and
   wherein the radius of curvature respects the relationship $R = h_2 / 2\varepsilon$,
   **characterized in that**
   the thickness of the second substrate (2) respects the relationship $h_2 / h_1 \geq 10^4$.

2. Method according to claim 1, **characterized in that** the first substrate (1) comprises a first portion forming the active layer (10) and a second portion (11), and **in that** the method comprises a step d1) consisting in decreasing the thickness of the second portion (11) of the first substrate (1).

3. Method according to claim 2, **characterized in that** step d1) is carried out so that the first substrate (1) remains self-supporting, step d1) being carried out before step c).

4. Method according to claim 2, **characterized in that** step d1) is carried out so as to remove substantially the entirety of the second portion (11) of the first substrate (1), step d1) being carried out after step d) and before step e).

5. Method according to one of claims 1 to 4, **characterized in that** the second substrate (2) comprises two lateral end portions (20), and **in that** the method comprises a step c1) consisting in arranging at least one reinforcing member (5) in each lateral end portion (20), each reinforcing member (5) preferably being needle-shaped.

6. Method according to one of claims 1 to 5, **characterized in that** it comprises a step c2) consisting in joining a layer forming a stiffener (4) to the second substrate (2), step c2) being carried out before step c).

7. Method according to claim 6 in combination with claim 5, **characterized in that** each reinforcing member (5) extends from the layer forming a stiffener (4).

8. Method according to one of claims 1 to 7, **characterized in that** the second material of the second substrate (2) respects the relationship $E_2 / E_1 \leq 10^{-3}$, and **in that** the thickness of the second substrate (2) respects the relationship $h_2 / h_1 \geq 10^5$.

9. Method according to one of claims 1 to 8, **characterized in that** the second material of the second substrate (2) respects the relationship $E_2 / E_1 \leq 10^{-4}$, and **in that** the thickness of the second substrate (2) respects the relationship $h_2 / h_1 \geq 10^6$.

10. Method according to one of claims 1 to 9, **characterized in that** the thickness of the active layer (10) is comprised between 5 nm and 50 nm, preferably is comprised between 5 nm and 35 nm, and **in that** the thickness of the second substrate (2) is comprised between 1 cm and 10 cm.

11. Method according to one of claims 1 to 10, **characterized in that** the radius of curvature is comprised between 0.5 m and 2 m in absolute value.

12. Method according to one of claims 1 to 11, **characterized in that** the second material of the second substrate (2) is an elastomer, preferably selected from the group comprising polydimethylsiloxane, polymethyl methacrylate, polyamides such as PA 6-3-T and polytetrafluoroethylene.

13. Method according to one of claims 1 to 12, **characterized in that** the first material of the active layer (10) is a semiconductor material, preferably selected from the group comprising Si, Ge, IV-IV materials such as Si-Ge, III-V materials such as GaN, GaAs, InP, InGaAs, and II-VI materials.

14. Method according to one of claims 1 to 12, **characterized in that** the first material of the active layer (10) is a piezoelectric material, preferably selected from the group comprising lead zirconate titanate, ZnO, GaN, AlN, quartz, $LiNbO_3$, $LiTaO_3$, $BaTiO_3$ and tourmaline.

**15.** Method according to one of claims 1 to 14, **characterized in that** it comprises a step f) consisting in transferring the active layer (10) to a final substrate (3), then comprises a step g) consisting in removing the second substrate (2).

**16.** Structure for modifying an initial strain state of what is referred to as an active layer (10) to a final strain state denoted $\varepsilon$, the structure comprising:

- a substrate (2);
- the active layer (10) surmounting the substrate (2),

the active layer (10) being made of a first material having a Young's modulus denoted $E_1$, the active layer (10) having a thickness denoted $h_1$, the substrate (2) being made of a second material having a Young's modulus denoted $E_2$, the substrate (2) having a thickness denoted $h_2$, the substrate (2) and the active layer (10) having a curved shape of a radius of curvature denoted R,
wherein the second material of the substrate (2) is a flexible material respecting the relationship $E_2 / E_1 < 10^{-2}$, and
wherein the radius of curvature respects the relationship $R = h_2 / 2\varepsilon$,
**characterized in that**
the thickness of the substrate (2) respects the relationship $h_2 / h_1 \geq 10^4$.

**17.** Structure according to claim 16, **characterized in that** the substrate (2) comprises two lateral end portions (20), and **in that** the structure comprises at least one reinforcing member (5) arranged in each lateral end portion (20), each reinforcing member (5) preferably being needle-shaped.

**18.** Structure according to claim 16 or 17, **characterized in that** it comprises a layer forming a stiffener (4) joined to the substrate (2).

**19.** Structure according to claim 18 in combination with claim 17, **characterized in that** each reinforcing member (5) extends from the layer forming a stiffener (4).

**20.** Structure according to one of claims 16 to 19, **characterized in that** the second material of the substrate (2) is an elastomer, preferably selected from the group comprising polydimethylsiloxane, polymethyl methacrylate, polyamides such as PA 6-3-T and polytetrafluoroethylene.

**21.** Structure according to one of claims 16 to 20, **characterized in that** the first material of the active layer (10) is a semiconductor material, preferably selected from the group comprising Si, Ge, IV-IV materials such as Si-Ge, III-V materials such as GaN, GaAs, InP, InGaAs, and II-VI materials.

**22.** Structure according to one of claims 16 to 20, **characterized in that** the first material of the active layer (10) is a piezoelectric material, preferably selected from the group comprising lead zirconate titanate, ZnO, GaN, AlN, quartz, $LiNbO_3$, $LiTaO_3$, $BaTiO_3$ and tourmaline.

**Fig 1a**

**Fig 1b**

**Fig 1c**

**Fig 1d**

2

10

**Fig 1e**

10

2

2

**Fig 1f**

10

3

**Fig 1g**

Fig 2a

Fig 2b

Fig 3

**EP 2 915 184 B1**

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070037323 A

**Littérature non-brevet citée dans la description**

- **K.T. TURNER.** Fabricating Strained Silicon Substrates Using Mechanical Deformation during Wafer Bonding. *ECS Transactions,* 2008, vol. 16 (8), 321-328